# EUROPÄISCHE PATENTSCHRIFT

(11) **EP 2 302 987 B1**
(45) Veröffentlichungstag und Bekanntmachung des Hinweises auf die Patenterteilung: **18.04.2012**
(21) Anmeldenummer: 09012018.9
(22) Anmeldetag: 22.09.2009
(51) Int. Cl.: H05K 3/00, H05K 3/34, H01L 23/32

(54) **Integration von SMD-Bauteilen in ein IC-Gehäuse**
Integration of SMD components in an IC housing
Intégration de composants SMD dans un boîtier IC

(43) Veröffentlichungstag der Anmeldung: 30.03.2011
(73) Patentinhaber: Micronas GmbH, 79108 Freiburg (DE)
(72) Erfinder: Schinner, Felix, 79312 Emmendingen (DE); Joos, Christian, 79238 Ehrenkirchen (DE); Schmidt, Michael, 77790 Steinach (DE); Hauser, Wolfgang, 79346 Endingen (DE); Burke, Thomas, 79104 Freiburg (DE)
(74) Vertreter: Koch Müller Patentanwaltsgesellschaft mbH

(56) Entgegenhaltungen:
- DE-A1- 19 714 385
- GB-A- 1 199 231
- JP-A- 60 003 141
- US-A- 4 818 823

## Beschreibung

Die Erfindung betrifft ein elektronisches Bauelement gemäß Oberbegriff des Patentanspruchs 1.

Ein solches elektronisches Bauelement ist aus der JP2004241579 A bekannt. Dieses elektronische Bauelement umfasst einen auf einer Trägerplattform eines Lead Frames befestigten Halbleiterchip sowie einen als SMD-Bauelement ausgebildeten Kondensator, der zwischen der als Masseanschluss dienenden Trägerplattform und einer Anschlussleitung zur Zuführung einer Betriebsspannung angeordnet ist. Zur Bildung eines Gehäuses ist der Halbleiterchip als auch das SMD-Bauelement mit einer Moldmasse vergossen.

Aus der GB119 923 1 A, der JP 600 0314 1 A und der US 4 818 823 A sind weitere Bauelemente bekannt, welche auf einem Lead Frames befestigt sind und teilweise ein SMD Bauteil in einem Gehäuse aufweisen.

Die Befestigung eines solchen SMD-Bauelements auf dem Lead Frame erfolgt mittels einer Klebeverbindung auf Epoxidbasis, wobei mittels Zusatzstoffen eine elektrisch leitende Verbindung hergestellt wird. Nachteilig hieran ist jedoch, dass es zum Ausbluten (epoxy bleeding) des Klebers kommt, so dass dadurch der Kleber sich unkontrolliert auf die Bondfinger ausbreiten kann, wodurch die Bondbarkeit nicht mehr gewährleistet ist.

Zur Lösung dieses Problems schlägt die DE 197 14 385 A1 ein Verfahren zur Begrenzung des Ausblutens von Kleber, insbesondere bei Befestigung von elektronischen Bauelementen in COB (Chip on board) -Bauweise vor, wonach durch verfahrensseitiges Aufbringen eines Hindernisses eine in sich geschlossene Barriere durch Verwendung von geeigneten Lacken, z. Bsp. von Lötstopplack gebildet wird. Bei diesem bekannten Verfahren wird diese Barriere als geschlossener Ring in dem Zwischenraum zwischen der Montagefläche eines Halbleiterchips und den zugehörigen Bondpads gelegt.

Der Nachteil dieses bekannten Verfahrens liegt nicht nur in dem zusätzlichen Aufwand zur Erzeugung einer entsprechenden Lötstoppmaske, sondern auch in zusätzlichen Prozessschritten. Je nach Art des verwendeten Lötstopplacks muss dieser nach dem Aufbringen auf den Chipträger ausgehärtet oder getrocknet, belichtet und entwickelt werden.

Aufgabe der Erfindung ist es, ein elektronisches Bauelement der eingangs genannten Art anzugeben, bei dem ein Ausbluten des Klebers mittels einfacher Maßnahmen wirkungsvoll verhindert wird, ohne die Nachteile des bekannten Verfahrens aufzuweisen.

Diese Aufgabe wird gelöst durch ein elektronisches Bauelement mit den Merkmalen des Patentanspruchs 1.

Bei einem solchen elektronischen Bauelement werden erfindungsgemäß die Trägerplattform als auch die Anschlussleitung im Bereich des SMD-Bauelements derart zu Erzeugung von Barrieren profiliert, dass ein Fließen von fließfähigem Material aus den mit dem SMD-Bauteil verbundenen Kontaktflächen des Chipträgers auf die Trägerplattform als auch auf die Anschlussleitung verhindert wird.

Diese Barrieren stellen eine wirksame Trennlinie für das fließfähige Material aus den Kontaktflächen des Chipträgers dar, die durch das SMD-Bauelement kontaktiert werden. Ferner zeichnet sich das erfindungsgemäße elektronische Bauelement besonders dadurch aus, dass der Fertigungsprozess im Backend nicht geändert werden muss, sondern der im Backend-Prozess verwendete Chipträger (Metallgitter, Leadframe) bereits die mechanischen Barrieren aufweist, die vorzugsweise als Gräben oder Erhebungen ausgebildet sind und durch einfaches Prägen in den Chipträger, bzw. den Leadframe im Rahmen dessen Herstellungsprozesses hergestellt werden können, wodurch insbesondere der Flächenbedarf für diese Art von Barrieren äußerst gering ist. Insgesamt führen diese Vorteile gegenüber dem bekannten Verfahren zu Kosteneinsparungen, sowohl hinsichtlich Material-und Werkzeugkosten als auch hinsichtlich kürzerer Prozesszeiten.

In einer Weiterbildung der Erfindung sind die Barrieren quer zur Fließrichtung des fließfähigen Materials angeordnet, wodurch eine optimale Ausrichtung hinsichtlich deren Funktion gewährleistet ist.

Es ist besonders vorteilhaft, wenn gemäß einer Weiterbildung der Erfindung die Barrieren geradlinig zwischen gegenüberliegenden Randbereichen der Trägerplattform bzw. der Anschlussleitungen derart verlaufen, dass die Kontaktflächen von dem übrigen Bereich der Trägerplattform bzw. der Anschlussleitung abgeteilt werden. Damit sind keine krummlinigen Barrieren erforderlich, wodurch sich bspw. zur Herstellung der Barrieren durch Prägeverfahren einfache Werkzeuge verwenden lassen.

Gemäß einer Weiterbildung der Erfindung weist die Trägerplattform zur Ausbildung der mit dem SMD-Bauelement verbundenen Kontaktfläche wenigstens ein Nasenelement auf, wobei die Barriere derart in die Trägerplattform profiliert ist, dass das Nasenelement im Übergangsbereich zur Trägerplattform von derselben abgeteilt wird. Damit lässt sich in besonders einfacher Weise dieses Nasenelement, das die Kontaktfläche für das SMD-Bauelement darstellt, von dem übrigen Bereich der Trägerplattform durch eine geradlinige Barriere abteilen.

Vorzugsweise ist die Trägerplattform mit mehreren solcher Nasenelemente ausgebildet, die jeweils eine Kontaktfläche aufweisen und jeweils über ein SMD-Bauelement mit einer Anschlussleitung verbunden sind, wobei die zugehörigen Barrieren auf der Trägerplatte als durchgehende Struktur hergestellt sind. Damit lässt sich mit einem Werkzeug eine Barriere herstellen, die sich entlang des Übergangsbereichs dieser Nasenelemente auf der Trägerplattform geradlinig erstreckt und gleichzeitig für alle Kontaktflächen auf den Nasenelementen als Barriere dient.

Vorzugsweise kann zwischen zwei solchen, Kontaktflächen für SMD-Bauelemente aufweisende Nasenelemente eine Anschlussleitung derart an die Trägerplattform angeformt sein, dass im Bereich der Nasenelemente ein vorgegebener Abstand zu den Nasenelementen eingehalten wird. Die den Kontaktflächen der beiden Nasenelemente zugeordneten Barrieren werden dabei über diese Anschlussleitung hinweg geradlinig verbunden, so dass diese vorteilhaft als einzelne Barriere hergestellt werden kann. Eine solche Anschlussleitung liegt in der Regel auf dem gleichen Potential wie das Halbleiter-Bauelement und dient als Masseanschluss. Hiermit ergeben sich große Freiheitsgrade hinsichtlich der Gestaltung des Chipträgers bzw. des Leadframes mit zugehörigen Barrieren.

Eine besonders vorteilhafte Weiterbildung der Erfindung ergibt sich dadurch, dass wenigstens eine Anschlussleitung mit einer mit dem SMD-Bauelement verbundenen Kontaktfläche und mit einem Bondfinger derart ausgebildet ist, dass sich der Bondfinger in Richtung der Anschlussleitung erstreckt und die Kontaktfläche hierzu im Wesentlichen rechtwinklig an die Anschlussleitung angeformt ist. Dadurch wird der Bereich auf der Anschlussleitung, der mit wenigstens einem Bonddraht kontaktiert wird, von demjenigen Bereich auf der Anschlussleitung, der die Kontaktfläche für das SMD-Bauelement ausbildet, geometrisch voneinander abgesetzt, so dass auch dadurch zusätzlich verhindert wird, dass fließfähiges Material, also bspw. der Kleber unter dem SMD-Bauelement in den Bondfinger fließen kann.

Bei einer weiteren Ausbildung der Erfindung sind die Anschlussleitungen innerhalb des Gehäuses in dessen Randbereich zur Erzeugung von zusätzlichen Barrieren profiliert, um das Eindringen von Feuchtigkeit von außen über diese Anschlussleitungen zu verhindern. Vorzugsweise erstrecken sich die zusätzlichen Barrieren auf den Anschlussleitungen parallel zu derjenigen Seitenfläche des Gehäuses, aus der die Anschlussleitungen jeweils aus dem Gehäuse austreten.

Weiterhin ist es gemäß einer Weiterbildung der Erfindung vorteilhaft, wenn die Trägerplattform wenigstens ein angeformtes, aus einer Gehäusefläche des Gehäuses herausragendes Nasenelement aufweist, und dieses Nasenelement zur Erzeugung einer innerhalb des Gehäuses verlaufenden Barriere profiliert ist, wobei sich diese Barriere parallel zu der Gehäusefläche erstreckt, aus der das Nasenelement herausragt. Dieses Nasenelement dient zur Abstützung der Trägerplattform während des Herstellungsprozesses des Gehäuses.

Schließlich ist es gemäß einer vorteilhaften Weiterbildung der Erfindung kostengünstig, die als Gräben und/oder als Erhebungen ausgebildete Barrieren durch Prägen der Trägerplattform und der Anschlussleitungen mittels eines Prägewerkzeugs während der Herstellung des Chipträges bzw. des Leadframes zu erzeugen, wobei bevorzugt die Gräben mit v-förmigen Querschnitt ausgebildet werden.

Die Erfindung wird nachstehend anhand eines Ausführungsbeispiels unter Bezugnahme auf die beigefügten Figuren ausführlich beschrieben. Es zeigen:
- Figur 1: eine schematische Darstellung in Draufsicht auf ein Ausführungsbeispiel eines erfindungsgemäßen elektro- nischen Bauelements,
- Figur 2: eine schematische Darstellung in Draufsicht auf ein weiteres Ausführungsbeispiel eines erfindungsgemäßen elektronischen Bauelements, und
- Figur 3: eine perspektivische Darstellung des erfindungsgemä- ßen elektronischen Bauelements nach Figur 2.

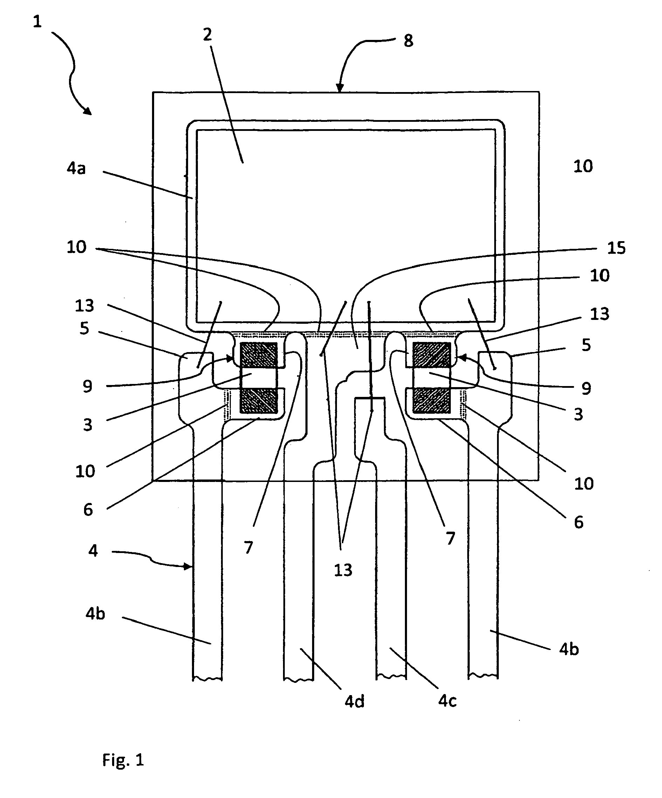

Das elektronische Bauelement 1 nach Figur 1 umfasst einen auf einer Trägerplattform 4a eines Chipträgers (Leadframe) 4 befestigten Halbleiterchip 2 sowie zwei passive SMD-Bauelemente 3, bspw. zwei Kapazitäten.

Die rechteckförmige Trägerplattform 4a weist auf einer Rechteckseite zwei rechteckförmige Nasenelemente 9 auf, die an die Trägerplattform 4a angeformt sind und jeweils eine Kontaktfläche 7 für ein Anschlussende eines der SMD-Bauelements 3 bilden. Die anderen Anschlussenden der SMD-Bauelemente 3 kontaktieren jeweils eine Anschlussfläche 6, die als rechteckförmiges Teil an einer Anschlussleitung (Leadfinger) 4b des Chipträgers 4 angeformt ist. Das der Trägerplattform 4a benachbarte Ende einer Anschlussleitung 4b bildet einen Bondfinger 5, wobei die Anschlussfläche 6 und dieser Bondfinger 5 rechtwinklig zueinander stehen. Der Halbleiterchip 2 ist über Bonddrähte 13 mit den Bondfingern 5 der beiden Anschlussleitungen 4b verbunden.

Die beiden SMD-Bauelemente 3 sind mittels eines leitfähigen Klebers auf Epoxidharzbasis mit den beiden Kontaktflächen 6 und 7 elektrisch verbunden. Um eine Ausbluten dieses Klebers aus diesen Kontaktflächen 6 und 7 in Richtung der Trägerplattform 4a und in Richtung der Anschlussleitungen 4b, insbesondere in Richtung der Bondfinger 5 zu verhindern, sind Barrieren 10 in das Material der Anschlussleitungen 4b als auch der Trägerplattform 4a eingeprägt.

Diese Barrieren 10 sind als Gräben oder Rillen mit v-förmigem Querschnitt ausgebildet und teilen die Kontaktflächen 6 und 7 von der übrigen Fläche der Anschlussleitung 4b bzw. der Trägerplattform 4a ab, indem diese Barrieren die gegenüberliegenden Ränder der Kontaktflächen 6 bzw. der Nasenelemente 9 geradlinig verbinden. Diese Barrieren 10 stellen damit eine wirksame Trennlinie für das fließfähige Material aus den Kontaktflächen 6 und 7 des Chipträgers 4 dar, die durch die beiden SMD-Bauelemente 3 kontaktiert werden.

Die Gefahr des Ausblutens (Epoxy Bleeding) wird zusätzlich auch dadurch reduziert, dass die Bondfinger 5 der Anschlussleitungen 4b und deren Kontaktflächen 6 geometrisch gegeneinander abgesetzt sind, also "über Eck" platziert sind, wie aus Figur 1 ersichtlich ist und oben bereits beschrieben wurde.

Gemäß Figur 1 ist zwischen den beiden Nasenelementen 9 eine weitere Anschlussleitung 4d vorgesehen, die über ein Nasenelement 15 als Übergangsteil an die Trägerplattform 4a angeformt ist und als Bondfinger für den Masseanschluss dient, wobei dieser Bondfinger über einen Bonddraht 13 mit dem Halbleiterchip 2 verbunden ist. Die Masseanbindung zwischen Nasenelement 15 und Halbleiterchip 2 könnte jedoch genauso gut anstelle des Bonddrahts 13 durch eine elektrische Rückseitenanbindung des Halbleiterchips 2 über einen leitfähigen Kleber erfolgen, d. h. der Halbleiterchip 2 ist dann mit seiner Rückseite auf den Chipträger 4 aufgeklebt. Hierbei sind die die Nasenelemente 9 von der Trägerplattform 4a abteilenden Barrieren 10 über dieses Übergangsteil 15 geradlinig verbunden, so dass auch dieses Nasenelement 15 von der Trägerplattform 4a abgeteilt wird. Der Zwischenraum zwischen den Nasenelementen 7 und 15 sind schlitzförmig ausgebildet und enden im Bereich der Barriere 10 halbkreisförmig. Damit ist auch der Bondfinger des zu der Anschlussleitung 4d gehörenden Nasenelements 15 vor ausblutendem Kleber aus den Kontaktflächen 7 geschützt.

Schließlich zeigt Figur 1 eine weitere Anschlussleitung 4c, die innerhalb des Gehäuses 8 einen Bondfinger aufweist, der über einen Bonddraht mit dem Halbleiterchip 2 verbunden ist.

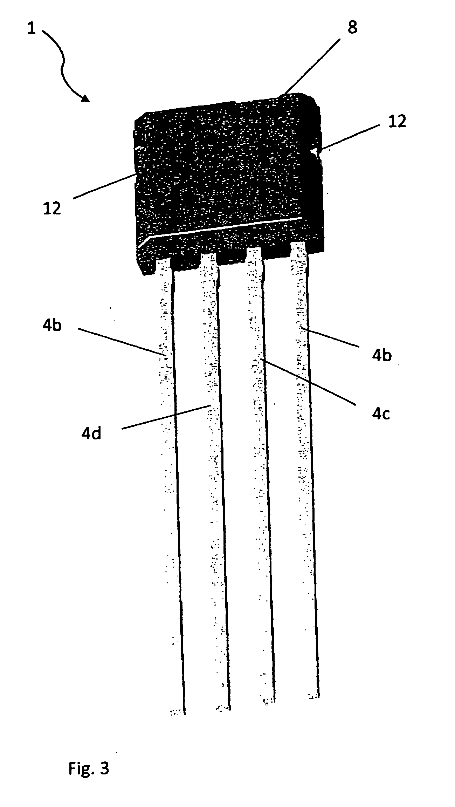

Das mittels einer Moldmasse in einem Mold-Prozess hergestellte Gehäuse 8 integriert sowohl das aktive Halbleiter-Bauelement 2 als auch das passive SMD-Bauelement 3 in einem THD-Gehäuse, wie dies bspw. prinzipiell in Figur 3 dargestellt ist.

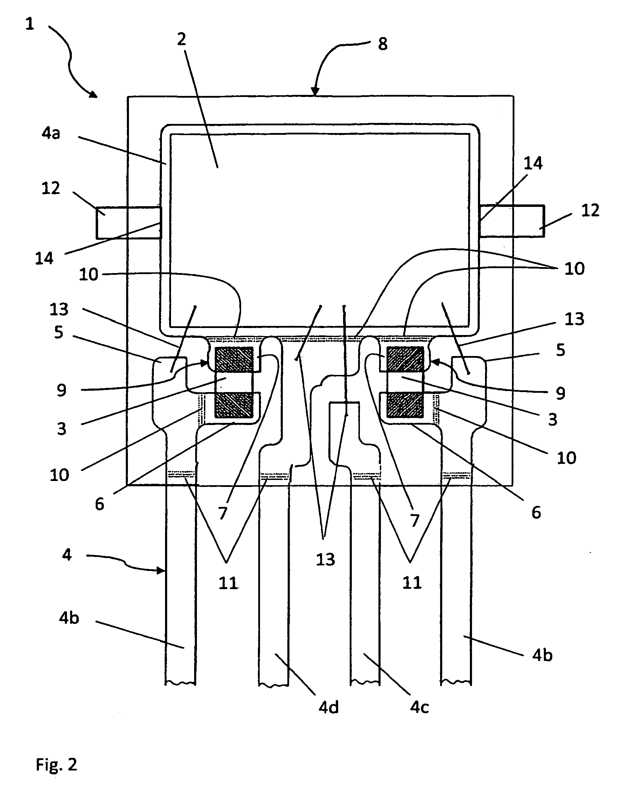

Das elektronische Bauelement 1 nach Figur 2 unterscheidet sich von demjenigen nach Figur 1 nur dadurch, dass an der Trägerplattform 4a auf gegenüberliegenden Seiten jeweils weitere Nasenelemente 12 angeformt sind, die aus dem Gehäuse 8 herausragen und zum Abstützen der Trägerplattform 4a durch ein Moldwerkzeug während des Mold-Prozesses des Gehäuses 8 dient, um dadurch ein Verkippen der Trägerplattform 4a während des Mold-Prozesses zu verhindern.

Ein weiterer Unterschied zu der Ausführungsform nach Figur 1 besteht darin, dass der Chipträger (Leadframe) 4 nach Figur 2 weitere Barrieren 11 und 14 aufweist, die als Gräben mit v-förmigem Querschnitt in das Material des Chipträgers 4 eingeprägt sind.

So sind die Barrieren 11 im Radbereich innerhalb des Gehäuses 8 auf den Anschlussleitungen (Leadfinger) 4b, 4c, und 4d quer zu deren Längsrichtung, also parallel zum Rand des Gehäuses 8 angeordnet. Die Barrieren 14 sind ebenso innerhalb des Gehäuses 8 so angeordnet, dass sie die Nasenelemente 12 von der Trägerplattform 4a abtrennen. Diese Barrieren 11 und 14 dienen dazu, das Eindringen von Feuchtigkeit in das Gehäuse 8 zu verhindern.

Figur 3 zeigt in perspektivischer Sicht das gemoldete elektronische Bauelement 1, das sowohl das aktive Halbleiter-Bauelement 2 als auch das SMD-Bauelement 3 in dem Gehäuse 8 integriert. Insbesondere sind die beiden aus dem Gehäuse 8 ragenden Nasenelemente 12 in dieser Figur 3 zu erkennen.

### Bezugszeichenliste

- 1: Elektronisches Bauelement
- 2: Halbleiter-Bauelement, Halbleiterchip
- 3: SMD-Bauelement
- 4: Chipträger
- 4a: Trägerplattform
- 4b: Anschlussleitungen
- 4c: Anschlussleitung
- 4d: Anschlussleitung
- 5: Bondfinger
- 6: Kontaktfläche
- 7: Kontaktfläche
- 8: Gehäuse
- 9: Nasenelement
- 10: Barriere
- 11: zusätzliche Barriere
- 12: weiteres Nasenelement
- 13: Bonddraht
- 14: zusätzliche Barriere
- 15: Nasenteil als Übergangsteil von Anschlussleitung 4d

## Patentansprüche

1. Elektronisches Bauelement (1) umfassend
- einen Halbleiterchip (2) und ein SMD-Bauelement (3),
- einen Chipträger (4) mit einer Trägerplattform (4a) und mit Anschlussleitungen (4b, 4c,), wobei auf der Trägerplattform (4a) das Halbleiterchip (2) befestigt ist, und das Halbleiterchip (2) elektrisch durch Chipbonden mit Bondfinger (5) der Anschlussleitungen (4b, 4c) verbunden ist,
- das SMD-Bauelement (3) die Trägerplattform (4a) mit einer Anschlussleitung (4b) mittels auf der Trägerplattform (4a) und der Anschlussleitung (4b) angeordneten Kontaktflächen (6, 7) verbindet,
**dadurch gekennzeichnet, dass**
- auf der Trägerplattform (4a) Richtung Anschlussleitungen (4b-4c) als auch auf der Anschlussleitung (4b) im Bereich des SMD-Bauelements (3) mittels einer Profilierung eine Barriere (10) ausgebildet ist, um ein Fließen von fließfähigem Material aus den Kontaktflächen (6, 7) zu verhindern, und
- die Barrieren (10) geradlinig zwischen gegenüberliegenden Randbereichen der Trägerplattform (4a) bzw. der Anschlussleitung (4b) verlaufen, so dass die Kontaktflächen (6, 7) von dem übrigen Bereich der Trägerplattform (4a) bzw. der Anschlussleitung abgeteilt werden.

2. Elektronisches Bauelement (1) nach Anspruch 1, **dadurch gekennzeichnet, dass** die Barrieren (10) quer zur Fließrichtung des fließfähigen Materials angeordnet sind.

3. Elektronisches Bauelement (1) nach Anspruch 1 oder Anspruch 2, **dadurch gekennzeichnet, dass** ein Gehäuse (8) vorgesehen ist, welches das Halbleiterbauelement (2), das SMD-Bauelement (3) und wenigstens teilweise den Chipträger (4) umhüllt.

4. Elektronisches Bauelement (1) nach einen der vorangegangenen Ansprüche, **dadurch gekennzeichnet, dass** zur Ausbildung der mit dem SMD-Bauelement (3) verbundenen Kontaktfläche (7) der Trägerplattform (4a) dieselbe wenigstens ein Nasenelement (9) aufweist, wobei die Barriere (10) derart in die Trägerplattform (4a) profiliert ist, dass das Nasenelement (9) im Übergangsbereich zur Trägerplattform (4a) von derselben abgeteilt wird.

5. Elektronisches Bauelement (1) nach Anspruch 4, **dadurch gekennzeichnet, dass** die Trägerplattform (4a) mehrere Nasenelemente (9) mit jeweils einer Kontaktfläche (7) aufweist, die jeweils über ein SMD-Bauelement (3) mit einer Anschlussleitung (4b) verbunden sind, wobei die zugehörigen Barrieren (10) auf der Trägerplatte (4a) miteinander verbunden sind.

6. Elektronisches Bauelement (1) nach Anspruch 5, **dadurch gekennzeichnet, dass** zwischen zwei Nasenelementen (9) zur Verbindung mit jeweils einem SMD-Bauelement (3) eine Anschlussleitung (4d) derart an die Trägerplattform (4a) angeformt ist, dass im Bereich der Nasenelemente (9) eine vorgegebener Abstand zu den Nasenelementen (9) eingehalten wird.

7. Elektronisches Bauelement (1) nach einem der vorhergehenden Ansprüche, **dadurch gekennzeichnet, dass** wenigstens eine Anschlussleitung (4b) mit einer mit dem SMD-Bauelement (3) verbundenen Kontaktfläche (6) und mit einem Bondfinger (5) derart ausgebildet ist, dass sich der Bondfinger (5) in Richtung der Anschlussleitung (4b) erstreckt und die Kontaktfläche (6) hierzu im Wesentlichen rechtwinklig an die Anschlussleitung (4b) angeformt ist.

8. Elektronisches Bauelement (1) nach einen der Ansprüche 1 bis 8, **dadurch gekennzeichnet, dass** die Anschlussleitungen (4b, 4c, 4d) innerhalb des Gehäuses (8) in dessen Randbereich zur Erzeugung von zusätzlichen Barrieren (11) profiliert sind.

9. Elektronisches Bauelement (1) nach Anspruch 8, **dadurch gekennzeichnet, dass**
die Anschlussleitungen (4b, 4c, 4d) derart profiliert sind, dass sich die zusätzlichen Barrieren (11) auf den Anschlussleitungen (4b, 4c, 4d) parallel zu derjenigen Seitenfläche des Gehäuses (8) erstrecken, aus der die Anschlussleitungen (4b, 4c, 4 d) jeweils aus dem Gehäuse (8) austreten.

10. Elektronisches Bauelement (1) nach einem der vorhergehenden Ansprüche, **dadurch gekennzeichnet, dass**
die Trägerplattform (4a) wenigstens eine angeformtes, aus einer Gehäusefläche des Gehäuses (8) herausragendes Nasenelement (12) aufweist, und dieses Nasenelement (12) zur Erzeugung einer innerhalb des Gehäuses (8) verlaufenden Barriere (13) profiliert ist, wobei sich diese Barriere (13) parallel zu der Gehäusefläche erstreckt, aus der das Nasenelement (12) herausragt.

11. Elektronisches Bauelement (1) nach einem der vorhergehenden Ansprüche, **dadurch gekennzeichnet, dass**
die Barrieren (10, 11, 12) als Graben und / oder als Erhebung ausgebildet sind.

12. Elektronisches Bauelement (1) nach Anspruch 11, **dadurch gekennzeichnet, dass**
die als Gräbern und / oder als Erhebungen ausgebildete Barrieren (10, 11, 12) durch Prägen der Trägerplattform (4a) und der Anschlussleitungen (4b, 4c, 4d) erzeugt werden.

13. Elektronisches Bauelement (1) nach einem der vorhergehenden Ansprüche, **dadurch gekennzeichnet, dass**
die als Gräbern und / oder als Erhebungen ausgebildete Barrieren (10, 11, 12) einen V-förmigen Querschnitt aufweisen.

14. Elektronisches Bauelement (1) nach Anspruch 11, **dadurch gekennzeichnet, dass**
die Grabentiefe der als Gräben ausgebildete Barrieren 1/10 der Dicke des Chipträgers beträgt.

## Claims

1. Electronic component (1) comprising
- a semiconductor chip (2) and an SMD component (3),
- a chip carrier (4) with a support platform (4a) and with connecting lines (4b, 4c), wherein the semiconductor chip (2) is fastened on the support platform (4a) and the semiconductor chip (2) is electrically connected by chip-bonds with bond-fingers (5) of the connecting lines (4b, 4c),
- the SMD component (3) connects the support platform (4a) with a connecting line (4b) by means of contact areas (6, 7) arranged on the support platform (4a) and the connecting line (4b),
**characterised in that**
- a barrier (10) is formed by means of profiling on the support platform (4a) in the direction of the connecting lines (4b, 4c) and also on the connecting line (4b) in the region of the SMD component (3) in order to prevent flow of flowable material out of the contact areas (6, 7) and
- the barriers (10) extend rectilinearly between opposite edge regions of the support platform (4a) or the connecting line (4b) so that the contact areas (6, 7) are divided off by the remaining region of the support platform (4a) or the connecting line.

2. Electronic component (1) according to claim 1, **characterised in that** the barriers (10) are arranged transversely to the flow direction of the flowable material.

3. Electronic component (1) according to claim 1 or claim 2, **characterised in that** a housing (8) is provided, which encases the semiconductor component (2), the SMD component (3) and at least in part the chip carrier (4).

4. Electronic component (1) according to any one of the preceding claims, **characterised in that** for formation of the contact area (7), which is connected with the SMD component (3), of the support platform (4a) the same has at least one lug element (9), wherein the barrier (10) is profiled in such a manner in the support platform (4a) that in the transition region with respect to the support platform (4a) the lug element (9) is offset therefrom.

5. Electronic component (1) according to claim 4, **characterised in that** the support platform (4a) has a plurality of lug elements (9) each with a respective contact area (7), which are each connected by way of an SMD component (3) with a connecting line (4b), wherein the associated barriers (10) on the support platform (4a) are connected together.

6. Electronic component (1) according to claim 5, **characterised in that** a connecting line (4d) for connection with a respective SMD component (3) is so formed on the support platform (4a) between two lug elements (9) that a predetermined spacing from the lug elements (9) is maintained in the region of the lug elements (9).

7. Electronic component (1) according to any one of the preceding claims, **characterised in that** at least one connecting line (4b) with a contact area (6), which is connected with the SMD component (3), and with a bond-finger (5) is constructed in such a manner that the bond-finger (5) extends in the direction of the connecting line (4b) and the contact area (6) is for this purpose formed to be substantially at right angles to the connecting element (4b).

8. Electronic component (1) according to any one of claims 1 to 8, **characterised in that** the connecting lines (4b, 4c, 4d) within the housing (8) are profiled in the edge region thereof in order to produce additional barriers (11).

9. Electronic component (1) according to claim 8, **characterised in that** the connecting lines (4b, 4c, 4d) are so profiled that the additional barriers (11) extend on the connecting lines (4b, 4c, 4d) parallel to that side surface of the housing (8) from which the connecting lines (4b, 4c, 4d) respectively exit from the housing (8).

10. Electronic component (1) according to any one of the preceding claims, **characterised in that** the support platform (4a) comprises at least one integrally formed lug element (12) protruding out of a housing surface of the housing (8) and this lug element (9) is profiled in order to produce a barrier (13) extending within the housing (8), wherein this barrier (13) extends parallel to the housing surface from which the lug element (12) protrudes.

11. Electronic component (1) according to any one of the preceding claims, **characterised in that** the barriers (10, 11, 12) are formed as trenches and/or elevations.

12. Electronic component (1) according to any one of the preceding claims, **characterised in that** barriers (10, 11, 12) formed as trenches and/or elevations are produced by stamping the support platform (4a) and the connecting lines (4b, 4c, 4d).

13. Electronic component (1) according to any one of the preceding claims, **characterised in that** barriers (10, 11, 12) formed as trenches and/or elevations have a V-shaped cross-section.

14. Electronic component (1) according to claim 11, **characterised. in that** the trench depth of the barriers formed as trenches is 1/10 of the thickness of the chip carrier.

## Revendications

1. Composant (1) électronique, comprenant :
- une puce électronique à semi-conducteur (2) et un composant SMD (3),
- un support de puce électronique (4) avec une plateforme de support (4a) et des lignes de raccordement (4b, 4c), la puce électronique à semi-conducteur (2) étant fixée sur la plateforme de support (4a), et la puce électronique à semi-conducteur (2) étant reliée électriquement par des connexions pour puces électroniques à des doigts de connexion (5) des lignes de raccordement (4b, 4c),
- le composant SMD (3) relie la plateforme de support (4a) à une ligne de raccordement (4b), au moyen de faces de contact (6, 7) disposées sur la plateforme de support (4a) et la ligne de raccordement (4b),
**caractérisé en ce que**
- sur la plateforme de support (4a), dans la direction des lignes de raccordement (4b - 4c), ainsi que sur la ligne de raccordement (4b), dans la zone du composant SMD (3), au moyen d'un profilage, est réalisée une barrière (10), pour éviter un écoulement de matériau susceptible de s'écouler, à partir des faces de contact (6, 7), et
- les barrières (10) s'étendent en ligne droite, entre des zones de bordure opposées de la plateforme de support (4a) ou de la ligne de raccordement (4b), de manière à ce que les faces de contact (6, 7) soient séparées de la zone restante de la plateforme de support (4a) ou de la ligne de raccordement.

2. Composant (1) électronique selon la revendication 1, **caractérisé en ce que** les barrières (10) sont disposées transversalement à la direction d'écoulement du matériau susceptible de s'écouler.

3. Composant (1) électronique selon la revendication 1 ou la revendication 2, **caractérisé en ce qu'**est prévu un boîtier (8), enveloppant le composant à semi-conducteur (2), le composant SMD (3) et au moins partiellement le support de puce électronique (4).

4. Composant (1) électronique selon l'une des revendications précédentes, **caractérisé en ce que**, pour réaliser la face de contact (7), reliée au composant SMD (3), de la plateforme de support (4a), celle-ci présente au moins un élément formant nez (9), la barrière (10) étant profilée dans la plateforme de support (4a), de manière que l'élément formant nez (9), soit séparé de celle-ci dans la zone de transition à la plateforme de support (4a).

5. Composant (1) électronique selon la revendication 4, **caractérisé en ce que** la plateforme de support (4a) présente plusieurs éléments formant nez (9), avec à chaque fois une face de contact (7), ceux-ci étant chacun reliés à une ligne de raccordement (4b), par l'intermédiaire d'un composant SMD (3), les barrières (10) afférentes étant reliées ensemble sur la plaque support (4a).

6. Composant (1) électronique selon la revendication 5, **caractérisé en ce que**, entre deux éléments formant nez (9), pour assurer la liaison avec chaque composant SMD (3), est formée d'un seul tenant sur la plateforme de support (4a) une ligne de raccordement (4d), de manière à ce qu'un espacement prédéterminé par rapport aux éléments formant nez (9) soit respecté dans la zone des éléments formant nez (9).

7. Composant (1) électronique selon l'une des revendications précédentes, **caractérisé en ce qu'**au moins une ligne de raccordement (4b) est réalisée avec une face de contact (6) reliée au composant SMD (3) et avec un doigt de connexion (5), de manière à ce que le doigt de connexion (5) s'étende en direction de la ligne de raccordement (4b) et que la face de contact (6) soit formée à cet effet sensiblement perpendiculairement d'un seul tenant sur la ligne de raccordement (4b).

8. Composant (1) électronique selon l'une des revendications 1 à 7, **caractérisé en ce que** les lignes de raccordement (4b, 4c, 4d), à l'intérieur du boîtier (8), sont profilées dans sa zone de bordure, de manière à produire des barrières (11) supplémentaires.

9. Composant (1) électronique selon la revendication 8, **caractérisé en ce que** les lignes de raccordement (4b, 4c, 4d) sont profilées de manière à ce que les barrières (11) supplémentaires situées sur les lignes de raccordement (4b, 4c, 4d) s'étendent parallèlement à la face latérale du boîtier (8), d'où les lignes de raccordement (4b, 4c, 4d) sortent à chaque fois du boîtier (8).

10. Composant (1) électronique selon l'une des revendications précédentes, **caractérisé en ce que** la plateforme de support (4a) présente au moins un élément formant nez (12), formé d'un seul tenant, ressortant d'une face du boîtier (8), et que cet élément formant nez (12) est profilé pour générer une barrière (13) s'étendant à l'intérieur du boîtier (8), cette barrière (13) s'étendant parallèlement à la face de boîtier de laquelle l'élément formant nez (12) ressort.

11. Composant (1) électronique selon l'une des revendications précédentes, **caractérisé en ce que** les barrières (10, 11, 12) sont réalisées sous la forme de tranchées et/ou d'élévation.

12. Composant (1) électronique selon la revendication 11, **caractérisé en ce que** les barrières (10, 11, 12) réalisées sous forme de tranchées et/ou d'élévations sont générées par embossage de la plateforme de support (4a) et des lignes de raccordement (4b, 4c, 4d).

13. Composant (1) électronique selon l'une des revendications précédentes, **caractérisé en ce que** les barrières (10, 11, 12) réalisées sous la forme de tranchées et/ou d'élévations présentent une section transversale en forme de V.

14. Composant (1) électronique selon la revendication 11, **caractérisé en ce que** la profondeur de tranchée des barrières réalisées sous la forme de tranchées est de 1/10 de l'épaisseur du support de puce électronique.
